# EUROPÄISCHE PATENTSCHRIFT

(11) **EP 0 290 670 B1**
(45) Veröffentlichungstag und Bekanntmachung des Hinweises auf die Patenterteilung: **29.06.1994**
(21) Anmeldenummer: 87116230.1
(22) Anmeldetag: 04.11.1987
(51) Int. Cl.: G03F 7/20, G03F 7/00, G02F 1/133

(54) **Verfahren zur Herstellung einer Struktur**
Pattern production process
Procédé pour réaliser une surface texturée

(30) Priorität: 11.04.1987 DE 3712335
(43) Veröffentlichungstag der Anmeldung: 17.11.1988
(73) Patentinhaber: VDO Adolf Schindling AG, D-60487 Frankfurt (DE)
(72) Erfinder: Stauss, Henning, D-6100 Darmstadt (DE)
(74) Vertreter: Klein, Thomas, Dipl.-Ing. (FH)

(56) Entgegenhaltungen:
- DE-A- 2 854 045
- FR-A- 2 297 093
- FR-A- 2 375 627
- IBM TECHNICAL DISCLOSURE BULLETIN. vol. 23, no. 5, Oktober 1980, NEW YORK US, Seite 1839, C.J. Hamel et al: "Negative-Acting Positive Photoresist"

## Beschreibung

Die Erfindung betrifft ein Verfahren zur Herstellung einer Struktur, bei welcher Teile der Struktur dicht nebeneinander auf einem durchsichtigen Substrat angeordnet sind, insbesondere zur Herstellung von Schaltelementen, die zwischen Leiterbahnen und Elektroden einer Flüssigkristallzelle vorgesehen sind.

Aus der DE-A-28 54 045 ist ein Verfahren zur Herstellung einer Struktur bekannt, bei dem das Substrat mit einer Positiv-Photoresist-Schicht versehen wird und außer einer normalen Belichtung eine weitere Belichtung durch das Substrat hindurch vorgenommen wird.

Bei Flüssigkristallzellen, die eine Vielzahl von Elektroden aufweisen, welche über von Leiterbahnen gebildete Datenleitungen getrennt ansteuerbar sind, sind zwischen den Leiterbahnen und den Elektroden Schaltelemente angeordnet, welche die Leiterbahnen mit der jeweiligen Elektrode verbinden, wenn an der Leiterbahn eine vorgegebene Mindestspannung anliegt. Diese Schaltelemente werden bei bekannten Flüssigkristallzellen als Metall-Isolator-Metall-Elemente (im folgenden MIM-Elemente genannt) ausgeführt. Neben ihrer Eigenschaft als Schaltelemente weisen die MIM-Elemente eine Kapazität auf, welche zusammen mit der Kapazität der Elektrode einen kapazitiven Spannungsteiler bildet. Dadurch gelangen auch im nichtleitenden Zustand Signalströme zur Elektrode, so daß bei zu großer Kapazität des MIM-Elements Störungen sichtbar werden.

Bei einer bereits vorgeschlagenen Flüssigkristallzelle ist vorgesehen, daß die Schaltelemente im wesentlichen von den sich jeweils gegenüberstehenden Kanten der Leiterbahnen und mit den Elektroden verbundener Leitstücke gebildet sind, wobei zwischen den Kanten eine Isolatorschicht angeordnet ist. Dadurch kann die Kapazität der Schaltelemente, insbesondere der MIM-Elemente, sehr gering gehalten werden.

Aufgabe der vorliegenden Erfindung ist es, ein vorteilhaftes Verfahren zur Herstellung von Strukturen, wie sie insbesondere bei der vorgeschlagenen Flüssigkristallzelle vorgesehen sind, anzugeben.

Das erfindungsgemäße Verfahren ist dadurch gekennzeichnet, daß das mit einem ersten Teil der Struktur bereits versehene Substrat mit einer Positiv-Umkehr-Photoresist-Schicht versehen wird, daß eine Belichtung durch eine inverse Maske erfolgt, die auf die Positiv-Umkehr-Photoresist-Schicht aufgelegt ist, daß vor einer Belichtung durch das Substrat eine Umkehrung der Positiv-Umkehr-Photoresist-Schicht vorgenommen wird, und daß eine weitere Belichtung durch das Substrat hindurch vorgenommen wird.

Das erfindungsgemäße Verfahren hat den Vorteil, daß zur Positionierung der beiden sich gegenüberstehenden Kanten des ersten und des zweiten Teils der Struktur keine ebenso genaue Positionierung einer Maske erforderlich ist. Durch die Anwendung einer Belichtung von der Rückseite des Substrats wird eine genaue relative Lage der beiden Kanten zueinander gewährleistet. Dabei werden Nachteile, die üblicherweise mit einer Rückseitenbelichtung verbunden sind, insbesondere die unscharfe Abbildung einer Maske, vermieden.

Bei dem erfindungsgemäßen Verfahren werden nämlich diejenigen Grenzen der Strukturen, welche nicht durch die sich gegenüberstehenden Kanten gegeben sind, mittels einer Belichtung durch eine Maske festgelegt, die auf die Positiv-Umkehr-Photoresist-Schicht aufgelegt ist. Dabei ist die Anwendung des Verfahrens nicht auf MIM-Elemente beschränkt. Es kann in vorteilhafter Weise auch zur Herstellung anderer Strukturen, bei denen Teile dicht nebeneinander auf einem Substrat angeordnet sind, angewendet werden - also beispielsweise zur Herstellung von Thin-Film-Transistoren bzw. Matrizen mit Thin-Film-Transistoren.

Eine vorteilhafte Weiterbildung der Erfindung besteht darin, daß vor der Belichtung durch die inverse Maske eine thermische Trocknung erfolgt, daß nach der Belichtung durch das Substrat die Positiv-Umkehr-Photoresist-Schicht entwickelt und dabei von derjenigen Fläche des Substrats, welche für ein zweites Teil der Struktur vorgesehen ist, entfernt wird, daß eine weitere Schicht für das zweite Teil der Struktur auf die Positiv-Umkehr-Photoresist-Schicht und die freie Fläche des Substrats aufgebracht wird und daß anschließend die Positiv-Umkehr-Photoresist-Schicht mit der weiteren Schicht entfernt wird.

Dabei kann die Umkehrung durch eine Temperung oder nach einem chemischen Verfahren erfolgen.

Zur Herstellung von Flüssigkristallzellen kann in vorteilhafter Weise vorgesehen sein, daß das erste Teil der Struktur eine anodisierte metallische Leiterbahn - vorzugsweise Tantal - ist und/oder daß die weitere Schicht aus einem zweiten Metall besteht. Als weitere Schicht kann jedoch auch ein Halbleiter oder Metalloxid vorgesehen sein.

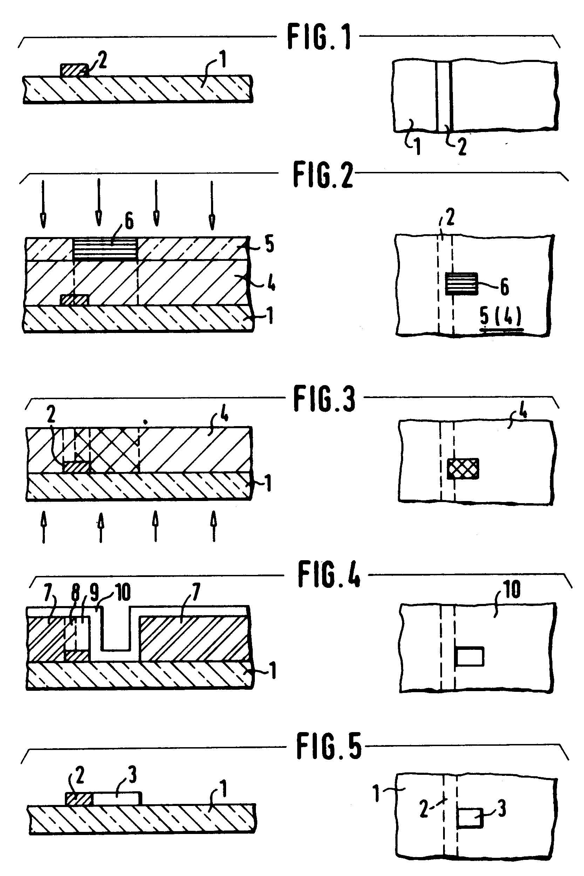

Die Erfindung läßt zahlreiche Ausführungsformen zu. Eine davon ist schematisch in der Zeichnung an Hand mehrerer Figuren dargestellt und nachfolgend beschrieben. Dabei werden mehrere Schritte des erfindungsgemäßen Verfahrens an Hand von jeweils einem Schnittbild und einer Ansicht in den Figuren 1 bis 5 dargestellt, wobei der Übersichtlichkeit halber das Schnittbild im wesentlich größeren Maßstab als die Ansicht gezeigt wird.

Gleiche Teile sind in den Figuren mit gleichen Bezugszeichen versehen.

Fig. 1 zeigt einen Ausschnitt aus einem Substrat 1, auf welches eine Leiterbahn 2 aufgebracht ist, welche anodisiert und damit mit einer dünnen in den Figuren nicht dargestellten Tantaloxidschicht versehen ist. Mit der anodisierten Leiterbahn 2 bildet ein aus einem zweiten Metall bestehendes Leitstück 3 (Fig. 5) einen MIM-Kontakt. An diesen schließt sich dann in an sich bekannter Weise eine Bildelektrode an.

Bei dem in Fig. 2 dargestellten Schritt ist auf die Glasplatte 1 und die Leiterbahn 2 bereits eine Positiv-Umkehr-Photoresist-Schicht 4 - im folgenden Photoresist-Schicht genannt - aufgetragen, welche bereits einer thermischen Trocknung ausgesetzt war. Geeignete Photoresist-Lacke sind an sich bekannt. Ein geeignetes Erzeugnis wird unter der Bezeichnung AZ 1514 von der Firma Kalle, Niederlassung der Hoechst AG, vertrieben. Bezüglich weiterer Einzelheiten bei der Anwendung des Photoresist-Lacks wird auf die an sich bekannten Verfahrensvorschriften des Herstellers verwiesen.

Auf die Photoresist-Schicht 4 wird eine Maske 5 aufgelegt, die eine sogenannte inverse Maske ist, d. h. die herzustellenden Strukturen sind bei der Maske 5 lichtundurchlässig. Die lichtundurchlässige Fläche 6 der Maske 5 ist jeweils an drei Seiten entsprechend dem gewünschten Leitstück 3 begrenzt. Lediglich an der vierten Seite ragt die Fläche über den rechten Rand der Leiterbahn 2 hinaus. Nach der Belichtung durch die Maske (durch Pfeile in Fig. 2 dargestellt) wird die Maske entfernt und die Photoresist-Schicht 4 einer Temperung mit höherer Temperatur als bei der Trocknung ausgesetzt. Durch eine zweite Belichtung (Fig. 3), welche wesentlich intensiver als die erste sein kann und durch das Substrat 1 hindurch erfolgt, wird erreicht, daß bei der anschließenden Entwicklung nur derjenige Teil der Photoresist-Schicht, welcher bei der ersten Belichtung nicht, jedoch bei der zweiten Belichtung belichtet wurde, gelöst wird (Fig. 4).

Die zweifach belichteten Teile 7, die lediglich nur der ersten Belichtung ausgesetzten Teile 8 sowie die unbelichteten Teile 9 werden vom Entwickler nicht gelöst. Nach dem üblichen Spülen und Trocknen werden die Photoresist-Schicht und die frei gewordene Fläche des Substrats 1 mit einer weiteren Schicht (10) versehen, welche aus dem für das Leitstück 3 (Fig. 5) vorgesehenen Material besteht. Durch anschließende Lösung der Photoresist-Schicht wird die weitere Schicht 10 nach dem sogenannten Lift-off-Verfahren entfernt, so daß von der weiteren Schicht 10 lediglich das Leitstück 3 übrigbleibt (Fig. 5).

## Patentansprüche

1. Verfahren zur Herstellung einer Struktur, bei welcher Teile der Struktur dicht nebeneinander auf einem durchsichtigen Substrat angeordnet sind, insbesondere zur Herstellung von Schaltelementen, die zwischen Leiterbahnen und Elektroden einer Flüssigkristallzelle vorgesehen sind, dadurch gekennzeichnet,
daß das mit einem ersten Teil der Struktur bereits versehene Substrat mit einer Positiv-Umkehr-Photoresist-Schicht versehen wird,
daß eine Belichtung durch eine inverse Maske erfolgt, die auf die Positiv-Umkehr-Photoresist-Schicht aufgelegt ist,
daß vor einer Belichtung durch das Substrat eine Umkehrung der Positiv-Umkehr-Photoresist-Schicht vorgenommen wird, und
daß eine weitere Belichtung durch das Substrat hindurch vorgenommen wird.

2. Verfahren nach Anspruch 1, dadurch gekennzeichnet,
daß vor der Belichtung durch die inverse Maske eine thermische Trocknung erfolgt,
daß nach der Belichtung durch das Substrat die Positiv-Umkehr-Photoresist-Schicht entwickelt und dabei von derjenigen Fläche des Substrats, welche für ein zweites Teil der Struktur vorgesehen ist, entfernt wird,
daß eine weitere Schicht für das zweite Teil der Struktur auf die Positiv-Umkehr-Photoresist-Schicht und die freie Fläche des Substrats aufgebracht wird und
daß anschließend die Positiv-Umkehr-Photoresist-Schicht mit der weiteren Schicht entfernt wird.

3. Verfahren nach Anspruch 2, dadurch gekennzeichnet, daß die Umkehrung durch eine Temperung erfolgt.

4. Verfahren nach Anspruch 2, dadurch gekennzeichnet, daß die Umkehrung nach einem chemischen Verfahren erfolgt.

5. Verfahren nach einem der vorhergehenden Ansprüche, dadurch gekennzeichnet, daß der erste Teil der Struktur eine anodisierte metallische Leiterbahn - vorzugsweise Tantal - ist.

6. Verfahren nach einem der vorhergehenden Ansprüche, dadurch gekennzeichnet, daß die weitere Schicht aus einem Metall besteht.

7. Verfahren nach einem der Ansprüche 1 bis 5, dadurch gekennzeichnet, daß die weitere Schicht aus einem Halbleiter besteht.

8. Verfahren nach einem der Ansprüche 1 bis 5, dadurch gekennzeichnet, daß die weitere Schicht aus Metalloxid besteht.

## Claims

1. A method for the production of a structure in which parts of the structure are disposed closely fitting side by side on a transparent substrate, particularly for the production of switching elements which are provided between strip conductors and electrodes of a liquid crystal cell, characterised in that the substrate, which is already provided with a first part of the structure, is provided with a positive reversal photoresist layer,
that an exposure is effected through an inverse mask which is placed on the positive reversal photoresist layer,
that a reversal of the positive reversal photoresist layer is effected before an exposure through the substrate, and
that an additional exposure is effected through the substrate.

2. A method according to claim 1, characterised in that thermal drying is effected before the exposure through the inverse mask,
that after the exposure through the substrate the positive reversal photoresist layer is developed and is thereby removed from that face of the substrate which is provided for a second part of the structure,
that an additional layer for the second part of the structure is deposited on the positive reversal photoresist layer and on the free surface of the substrate, and
that the positive reversal photoresist layer is later removed with the additional layer.

3. A method according to claim 2, characterised in that the reversal is effected by annealing.

4. A method according to claim 2, characterised in that the reversal is effected by a chemical process.

5. A method according to any one of the preceding claims, characterised in that the first part of the structure is an anodised metallic strip conductor - preferably tantalum.

6. A method according to any one of the preceding claims, characterised in that the additional layer consists of a metal.

7. A method according to any one of claims 1 to 5, characterised in that the additional layer consists of a semiconductor.

8. A method according to any one of claims 1 to 5, characterised in that the additional layer consists of metal oxide.

## Revendications

1. Procédé de production d'une structure dans laquelle des parties de ladite structure sont agencées en juxtaposition intime sur un substrat transparent, notamment pour la production d'éléments de commutation prévus entre des pistes conductrices et des électrodes d'une cellule à cristaux liquides, caractérisé par le fait
que le substrat, déjà pourvu d'une première partie de la structure, est muni d'une couche photorésistante à inversion de positif ;
qu'une illumination a lieu à travers un masque inverse, placé sur la couche photorésistante à inversion de positif ;
qu'il est procédé, préalablement à une illumination à travers le substrat, à une inversion de la couche photorésistante à inversion de positif ; et
qu'il est procédé à une autre illumination à travers le substrat.

2. Procédé selon la revendication 1, caractérisé par le fait
qu'un séchage thermique a lieu avant l'illumination à travers le masque inverse ;
que, après l'illumination à travers le substrat, la couche photorésistante à inversion de positif est développée, en étant alors enlevée de la surface du substrat qui est prévue pour une seconde partie de la structure ;
qu'une couche supplémentaire, destinée à la seconde partie de la structure, est déposée sur la couche photorésistante à inversion de positif et sur la surface libre du substrat ; et que la couche photorésistante à inversion de positif est consécutivement enlevée avec la couche supplémentaire.

3. Procédé selon la revendication 2, caractérisé par le fait que l'inversion a lieu par un étuvage.

4. Procédé selon la revendication 2, caractérisé par le fait que l'inversion a lieu d'après un procédé chimique.

5. Procédé selon l'une des revendications précédentes, caractérisé par le fait que la première partie de la structure est une piste conductrice métallique anodisée - de préférence en du tantale -.

6. Procédé selon l'une des revendications précédentes, caractérisé par le fait que la couche supplémentaire consiste en un métal.

7. Procédé selon l'une des revendications 1 à 5, caractérisé par le fait que la couche supplémentaire consiste en un semi-conducteur.

8. Procédé selon l'une des revendications 1 à 5, caractérisé par le fait que la couche supplémentaire consiste en un oxyde métallique.
